# EUROPÄISCHE PATENTANMELDUNG

(11) **EP 3 439 445 A1**
(43) Veröffentlichungstag der Anmeldung: **06.02.2019**
(21) Anmeldenummer: 17184029.1
(22) Anmeldetag: 31.07.2017
(51) Int. Cl.: H05K 7/20

(54) **ENTWÄRMUNG VON LEISTUNGSHALBLEITERSCHALTERN MIT BREITEM BANDABSTAND IN EINEM ELEKTRISCHEN UMRICHTER**

(71) Anmelder: Siemens Aktiengesellschaft, 80333 München (DE)
(72) Erfinder: Fürst, Johannes, 92348 Stöckelsberg (DE); Diepold, Fabian, 93336 Altmannstein (DE); Tetzner, Thilo, 90491 Nürnberg (DE)

(57) **Zusammenfassung**

Die Erfindung betrifft einen elektrischen Umrichter (1), aufweisend einen Leistungshalbleiterschalter (2) mit breitem Bandabstand aus GaN oder aus InGaN, ein Trägerelement (3) zur mechanischen Aufnahme des Leistungshalbleiterschalters (2) und ein Gehäuse (4), in dessen Gehäuseinnenraum (5) das Trägerelement (3) mit dem Leistungshalbleiterschalter (2) angeordnet ist, wobei der Leistungshalbleiterschalter (2) im Betrieb des elektrischen Umrichters (1) mit einer Sperrspannung von mindestens 400V und mit einer Taktfrequenz von mindestens 40kHz betrieben wird und mindestens 60% bis zu 90% der durch den Leistungshalbleiterschalter (2) entstehenden Verlustwärme als eine erste Verlustwärme (6) zur Entwärmung an ein gasförmiges Umgebungsmedium (7) innerhalb des Gehäuseinnenraums (5) abgeführt wird.

## Beschreibung

Die Erfindung betrifft die Entwärmung eines Leistungshalbleiterschalters mit breitem Bandabstand aus GaN oder InGaN beim Einsatz in einem elektrischen Umrichter.

In elektrischen Umrichter kommen meist Leistungshalbleiterschalter zum Einsatz, welche Silizium (Si) als Halbleitermaterial aufweisen. Deren Eigenschaften sind hauptsächlich bestimmt durch den energetischen Abstand zwischen Valenzband und Leitungsband des Halbleiters. Während elektrische Leiter ohne Halbleitereigenschaften, wie z.B. Kupfer, keine Bandlücke besitzen, wird die Bandlücke bei elektrischen Nichtleitern mit größer 4eV angegeben.

Bei Si als alleinigem Halbleitermaterial liegt die Bandlücke mit Raumtemperatur bei 1,12eV.

Bei Halbleitern mit breitem Bandabstand, auch bekannt als Wide-Bandgap-Halbleiter ist die Bandlücke größer als 3eV. Diese Eigenschaft der Halbleiter mit breitem Bandabstand bietet prinzipiell Vorteile für Leistungshalbleiterschalter, weil beispielsweise beim Schalten eine geringere Verlustwärme erzeugt wird und der Leistungshalbleiterschalter mit einer höheren Sperrspannung und einer höheren Schaltfrequenz betrieben werden kann.

Ein Beispiel für den Einsatz von Halbleitern mit breitem Bandabstand in elektrischen Umrichtern sind Leistungshalbleiterschalter mit Verbindungshalbleitern aus Siliziumcarbid (SiC), was einer Kombination von Elementen der Gruppe IV des Periodensystems entspricht.

Trotz der Vorteile, welche beispielsweise Leistungshalbleiterschalter aus SiC bieten, werden diese Leistungshalbleiterschalter in elektrischen Umrichtern hoher Leistungsklassen (Betrieb der Leistungshalbleiterschalter mit mindestens 400V Sperrspannung und 40kHz Taktfrequenz) aufgrund ihrer Schalt- und Durchlassverluste, also ihrer im Betrieb entstehenden Verlustwärme, mittels teilweise massiver, mit dem Gehäuse verbundener metallischer Kühlkörper entwärmt. Oft macht ein derartiger Kühlkörper daher einen nicht unerheblichen Teil der Außenfläche und des Gesamtgewichtes des elektrischen Umrichters aus.

Auch steht eine derartige Entwärmung beim Einsatz von Halbleitern mit breitem Bandabstand einer Anforderung an die Hersteller von elektrischen Umrichtern entgegen, kompaktere und somit auch kleinere Produkte bei zumindest gleichbleibender oder höherer elektrischer Leistung anzubieten.

Dies gilt insbesondere auch für den Einsatz von sich vergleichsweise neu am Markt etablierenden Leistungshalbleiterschaltern mit breitem Bandabstand aus Galliumnitrid (GaN) oder Indiumgalliumnitrid (InGaN).

Der Erfindung liegt daher die Aufgabe zugrunde, einen elektrischen Umrichter bereitzustellen, bei dem die Entwärmung eines dort zum Einsatz kommenden Leistungshalbleiterschalters mit breitem Bandabstand aufwandsärmer, platzsparender und kostengünstiger als der Stand der Technik ist.

Die Aufgabe wird durch einen elektrischen Umrichter mit den in Anspruch 1 angegebenen Merkmalen gelöst.

Der Erfindung liegt die Erkenntnis zugrunde, dass insbesondere Leistungshalbleiterschalter mit Verbindungshalbleitern aus GaN oder InGaN, als Kombination von Elementen der Gruppe III-V des Periodensystems, Vorteile gegenüber beispielsweise den Leistungshalbleiterschaltern aus nur Si oder auch aus SiC aufweisen.

So zum Beispiel erzeugen Leistungshalbleiterschalter aus GaN oder InGaN aufgrund von deren großer Bandlücke mit 3,41eV weniger elektrische Verluste, also Verlustwärme, als Leistungshalbleiterschalter aus Si (Bandlücke 1,12eV).

Leistungshalbleiterschalter aus GaN oder InGaN können darüber hinaus auch mit höheren Schaltgeschwindigkeiten als beispielsweise Leistungshalbleiterschalter vergleichbarer Leistungsklassen aus SiC betrieben werden.

Diese Vorteile bieten die Möglichkeit, den Aufbau und die Wirkungsweise von elektrischen Umrichtern bzgl. deren Entwärmung von Leistungshalbleiterschaltern mit breitem Bandabstand aus GaN oder InGaN neu zu gestalten.

Für die Lösung der Aufgabe wird ein elektrischer Umrichter vorgeschlagen, aufweisend einen Leistungshalbleiterschalter mit breitem Bandabstand aus GaN oder aus InGaN, aufweisend ein Trägerelement zur mechanischen Aufnahme des Leistungshalbleiterschalters und aufweisend ein Gehäuse, in dessen Gehäuseinnenraum das Trägerelement mit dem Leistungshalbleiterschalter angeordnet ist, wobei der Leistungshalbleiterschalter im Betrieb des elektrischen Umrichters mit einer Sperrspannung von mindestens 400V und mit einer Taktfrequenz von mindestens 40kHz betrieben wird und wobei mindestens 60% bis zu 90% der durch den Leistungshalbleiterschalter entstehenden Verlustwärme als eine erste Verlustwärme zur Entwärmung an ein gasförmiges Umgebungsmedium innerhalb des Gehäuseinnenraums abgeführt wird.

Der überwiegende Teil der durch den Leistungshalbleiterschalter erzeugten Verlustwärme kann im Betrieb als erste Verlustwärme in vorteilhafter Weise demnach an das gasförmige Umgebungsmedium als Wärmesenke in den Gehäuseinnenraum des elektrischen Umrichters abgegeben werden. Als gasförmiges Umgebungsmedium wird meist die Luft im Gehäuseinnenraum verwendet.

Mittels des vorgeschlagenen elektrischen Umrichters ist es daher möglich, auf einen insbesondere metallischen Kühlkörper, welcher für die genannten Betriebsbedingungen der Sperrspannung von mindestens 400V und der Taktfrequenz von mindestens 40kHz bei heutigen Umrichtern zumindest Teil des Gehäuses ist, zu verzichten.

Vorteilhafte Ausgestaltungsformen des elektrischen Umrichters sind in den abhängigen Ansprüchen angegeben.

Bei einer ersten vorteilhaften Ausgestaltungsform des erfindungsgemäßen elektrischen Umrichters gibt der Leistungshalbleiterschalter im Betrieb des elektrischen Umrichters mindestens 10% bis zu 40% seiner entstehenden Verlustwärme als eine zweite Verlustwärme zur Entwärmung unmittelbar an das Trägerelement ab und wird von dort die zweite Verlustwärme mindestens zu 85% bis zu 95% an das gasförmige Umgebungsmedium innerhalb des Gehäuseinnenraums abgeführt.

Da der Leistungshalbleiterschalter mit dem Trägerelement mechanisch verbunden ist, wird im Betrieb ein Teil der Verlustwärme als zweite Verlustwärme in vorteilhafter Weise an das Trägerelement abgegeben. Diese zweite Verlustwärme wird ebenfalls zu einem überwiegenden Teil an das gasförmige Umgebungsmedium in den Gehäuseinnenraum abgeführt, ohne das ein Einsatz von weiteren Kühlkörpern, insbesondere von metallische Kühlkörpern, welche Teil des Gehäuses des elektrischen Umrichter sind, vorgesehen ist.

Ein kleiner Teil der zweiten Verlustwärme, zwischen 5% und 15%, kann dabei über eine oder mehrere elektrische Leiterbahnen am Trägerelement abgeführt werden, wobei dieser Teil der zweiten Verlustwärme ebenfalls überwiegend an das gasförmige Umgebungsmedium innerhalb des Gehäuseinnenraums abgeführt wird.

Bei einer weiteren vorteilhaften Ausgestaltungsform des erfindungsgemäßen elektrischen Umrichters wird die erste Verlustwärme des Leistungshalbleiterschalters unmittelbar an das gasförmige Umgebungsmedium innerhalb des Gehäuseinnenraums abgeführt.

Bei einer weiteren vorteilhaften Ausgestaltungsform des erfindungsgemäßen elektrischen Umrichters gibt der Leistungshalbleiterschalter im Betrieb des elektrischen Umrichters mindestens 60% bis zu 90% seiner entstehenden Verlustwärme als eine dritte Verlustwärme zur Entwärmung unmittelbar an ein in direktem thermischen Kontakt stehendes und ihn zumindest teilweise umschließendes wärmeleitfähiges, elektrisch nichtleitendes Material, insbesondere Vergussmaterial, ab und wird von dort die dritte Verlustwärme mindestens zu 85% bis zu 95% an das gasförmige Umgebungsmedium innerhalb des Gehäuseinnenraums abgeführt.

Dieses elektrisch nichtleitende und somit elektrisch isolierende Material kann in vorteilhafter Weise auch eine isolierende Wirkung des Leistungshalbleiterschalters gegenüber der Umwelt haben, also als Schutz gegen Verschmutzung und Feuchtigkeit verwendet werden. Ferner gibt es dem Leistungshalbleiterschalter auch eine erhöhte mechanische Stabilität im elektrischen Umrichter.

Auch diese dritte Verlustwärme wird ebenfalls zu einem überwiegenden Teil an das gasförmige Umgebungsmedium in den Gehäuseinnenraum abgeführt, ohne dass ein Einsatz von weiteren Kühlkörpern, insbesondere von metallische Kühlkörpern, welche Teil des Gehäuses des elektrischen Umrichter sind, vorgesehen ist.

Bei einer weiteren vorteilhaften Ausgestaltungsform des erfindungsgemäßen elektrischen Umrichters erfolgt die Abführung der Verlustwärme des Leistungshalbleiterschalters an das gasförmige Umgebungsmedium im Gehäuseinnenraum ausschließlich durch natürliche Konvektion.

Die Verwendung der natürlichen Konvektion zur Abführung der durch den Leistungshalbleiterschalter erzeugten Verlustwärme an das gasförmige Umgebungsmedium innerhalb des Gehäuseinnenraums des elektrischen Umrichters meint hier in vorteilhafter Weise die Anwendung der Konvektion ohne weitere technische Hilfsmittel.

Bei einer weiteren vorteilhaften Ausgestaltungsform des erfindungsgemäßen elektrischen Umrichters erfolgt die Abführung der Verlustwärme des Leistungshalbleiterschalters an das gasförmige Umgebungsmedium im Gehäuseinnenraum zumindest teilweise durch ein Mittel zur Erzeugung einer erzwungenen Konvektion.

Die Verwendung der erzwungenen Konvektion zur Abführung der durch den Leistungshalbleiterschalter erzeugten Verlustwärme an das gasförmige Umgebungsmedium innerhalb des Gehäuseinnenraums des elektrischen Umrichters meint hier die Anwendung eines Mittels zur Erzeugung der erzwungenen Konvektion wie das eines elektrischen Lüfters.

Durch die erzwungene Konvektion wird der weitere Abtransport der vom Leistungshalbleiterschalter erzeugten Verlustwärme in vorteilhafter Weise unterstützt, so dass sich einerseits der Wirkungsgrad des elektrischen Umrichters und andererseits auch der Schutz der Leistungshalbleiterschalter vor Überhitzung und Zerstörung weiter verbessern lassen.

Bei einer weiteren vorteilhaften Ausgestaltungsform des erfindungsgemäßen elektrischen Umrichters weist das Gehäuse eine oder mehrere Gehäuseöffnungen auf, mittels der im Betrieb des elektrischen Umrichters ein Austausch des erwärmten gasförmigen Umgebungsmediums des Gehäuseinnenraums gegen ein weiteres gasförmiges Umgebungsmedium außerhalb des Gehäuses durchgeführt wird.

Durch die Abfuhr des erwärmten gasförmigen Umgebungsmediums aus dem Gehäuseinnenraum bei gleichzeitiger Zufuhr des weiteren gasförmigen Umgebungsmediums von außerhalb des Gehäuses in den Gehäuseinnenraum, kann die vom Leistungshalbleiterschalter erzeugte Verlustwärme in vorteilhafter Weise aus dem Gehäuseinnenraum nach außerhalb des elektrischen Umrichters abgeleitet werden. Dadurch kann der Wirkungsgrad des elektrischen Umrichters und der Schutz der Leistungshalbleiterschalter vor Überhitzung und Zerstörung noch weiter verbessert werden.

Bei einer weiteren vorteilhaften Ausgestaltungsform des erfindungsgemäßen elektrischen Umrichters weist das Gehäuse mindestens zu 95% ein wärmeleitfähiges, nichtmetallisches Material, insbesondere Kunststoff, auf.

Mittels dieser vorteilhaften Ausgestaltungsform wird weitestgehend auf metallische Flächen bzw. Strukturen des Gehäuses, wie sie z.B. beim Einsatz von metallischen Kühlkörpern als Teil des Gehäuses notwendig sind, verzichtet. Dadurch kann das Gesamtgewicht des elektrischen Umrichters, dessen Größe sowie dessen Produktionsaufwand und damit die Kosten vorteilhaft reduziert werden.

Bei einer weiteren vorteilhaften Ausgestaltungsform des erfindungsgemäßen elektrischen Umrichters wird der Leistungshalbleiterschalter im Betrieb des elektrischen Umrichters mit einem Schaltstrom von mindestens 7A betrieben.

Bei einer weiteren vorteilhaften Ausgestaltungsform des erfindungsgemäßen elektrischen Umrichters weist der elektrische Umrichter als Leistungshalbleiterschalter mit breitem Bandabstand aus GaN oder aus InGaN einen ersten Leistungshalbleiterschalter und einen oder mehrere weitere Leistungshalbleiterschaltern auf, welche an einem ersten Trägerelement als Trägerelement oder an einem ersten Trägerelement und einem oder mehreren weiteren Trägerelementen als Trägerelement angeordnet sind.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine erste schematische Darstellung von entwärmbaren Leistungshalbleiterschaltern mit breitem Bandabstand eines erfindungsgemäßen elektrischen Umrichters,
- FIG 2: eine zweite schematische Darstellung ein Ausführungsbeispiels des erfindungsgemäßen elektrischen Umrichters nach FIG 1,
- FIG 3: eine dritte schematische Darstellung ein weiteres Ausführungsbeispiel des erfindungsgemäßen elektrischen Umrichters nach FIG 1 und
- FIG 4: eine vierte schematische Darstellung ein weiteres Ausführungsbeispiel des erfindungsgemäßen elektrischen Umrichters nach FIG 1.

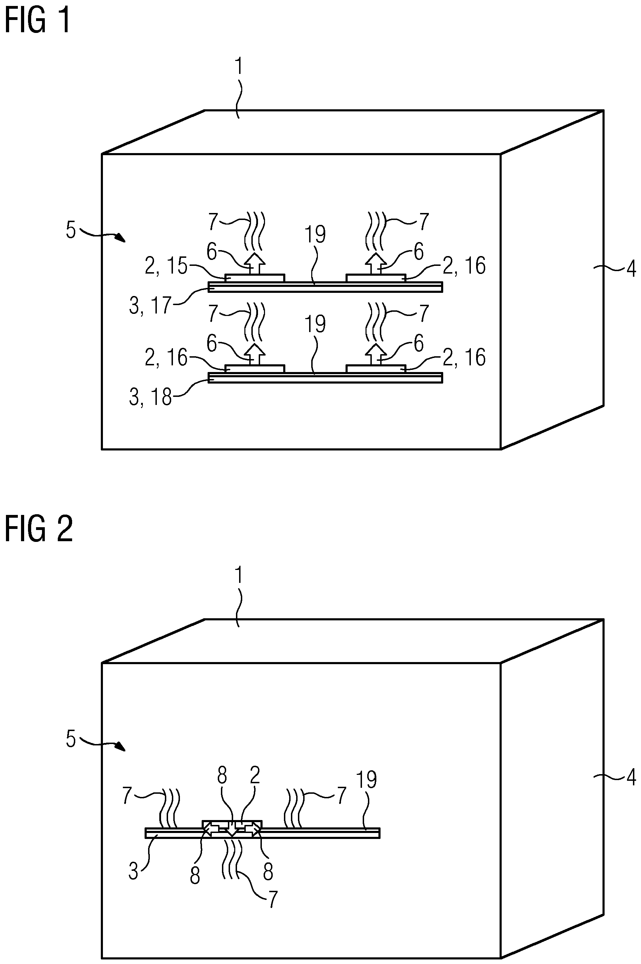

In FIG 1 zeigt eine erste schematische Darstellung von entwärmbaren Leistungshalbleiterschaltern 2,15,16 mit breitem Bandabstand aus GaN oder aus InGaN (in FIG 1 nicht im Detail gezeigt) eines erfindungsgemäßen elektrischen Umrichters 1.

Dabei sind ein erster Leistungshalbleiterschalter 15 und ein weiterer Leistungshalbleiterschalter 16, jeweils ausgeführt als Leistungshalbleiterschalter 2 des elektrischen Umrichters 1 mit breitem Bandabstand aus GaN oder aus InGaN, mit einem ersten Trägerelement 17, ausgeführt als Trägerelement 3 des elektrischen Umrichters 1, mechanisch verbunden.

Darüber hinaus sind weitere Leistungshalbleiterschalter 16, jeweils ausgeführt als Leistungshalbleiterschalter 2 des elektrischen Umrichters 1 mit breitem Bandabstand aus GaN oder aus InGaN, mit einem weiteren Trägerelement 18, ausgeführt als Trägerelement 3 des elektrischen Umrichters 1, mechanisch verbunden.

Im Betrieb des elektrischen Umrichters 1 erzeugen diese Leistungshalbleiterschalter 2,15,16 jeweils Verlustwärme, welche mindestens zu 60% bis zu 90% (in FIG 1 nicht im Detail gezeigt) als jeweils erste Verlustwärme 6 unmittelbar an ein gasförmiges Umgebungsmedium 7 in einen Gehäuseinnenraum 5 eines Gehäuses 4 des elektrischen Umrichters 1 abgeführt wird.

Das gasförmige Umgebungsmedium 7 verteilt die aufgenommene erste Verlustwärme 6 mittels Konvektion in den Gehäuseinnenraum 5, wobei eine weitere Entwärmung über das Gehäuse nach außerhalb des elektrischen Umrichters 1 erfolgt.

Das erste Trägerelemente 3,17 und das weitere Trägerelement 3,18 weisen im Ausführungsbeispiel der FIG 1 jeweils eine elektrische Leiterbahn 19 auf, welche jeweils elektrisch mit den jeweiligen Leistungshalbleiterschaltern 2,15,16 verbunden sein kann.

Mit FIG 2 wird eine zweite schematische Darstellung eines Ausführungsbeispiels des erfindungsgemäßen elektrischen Umrichters 1 nach FIG 1 aufgezeigt.

Der Leistungshalbleiterschalter 2 ist dabei mechanisch mit dem Trägerelement 3 verbunden. Das Trägerelement 3 weist die elektrische Leiterbahn 19 auf, welche mit dem Leistungshalbleiterschalter 2 elektrisch verbunden sein kann.

Im Betrieb des elektrischen Umrichters 1 erzeugt der Leistungshalbleiterschalter 2 eine Verlustwärme, welche mindestens zu 10% bis zu 40% (in FIG 2 nicht im Detail gezeigt) als zweite Verlustwärme 8 unmittelbar an das Trägerelement 3 abgegeben wird.

Vom Trägerelement wird die zweite Verlustwärme 8 mindestens zu 85% bis zu 95% (in FIG 2 nicht im Detail gezeigt) an das gasförmige Umgebungsmedium 7 in den Gehäuseinnenraum 5 des Gehäuses 4 des elektrischen Umrichters 1 abgeführt.

Zwischen 5% und 15% der zweiten Verlustwärme 8 kann dabei von der elektrischen Leiterbahn 19 aufgenommen und zumindest teilweise an das gasförmige Umgebungsmedium 7 in den Gehäuseinnenraum 5 des Gehäuses 4 des elektrischen Umrichters 1 abgeführt werden.

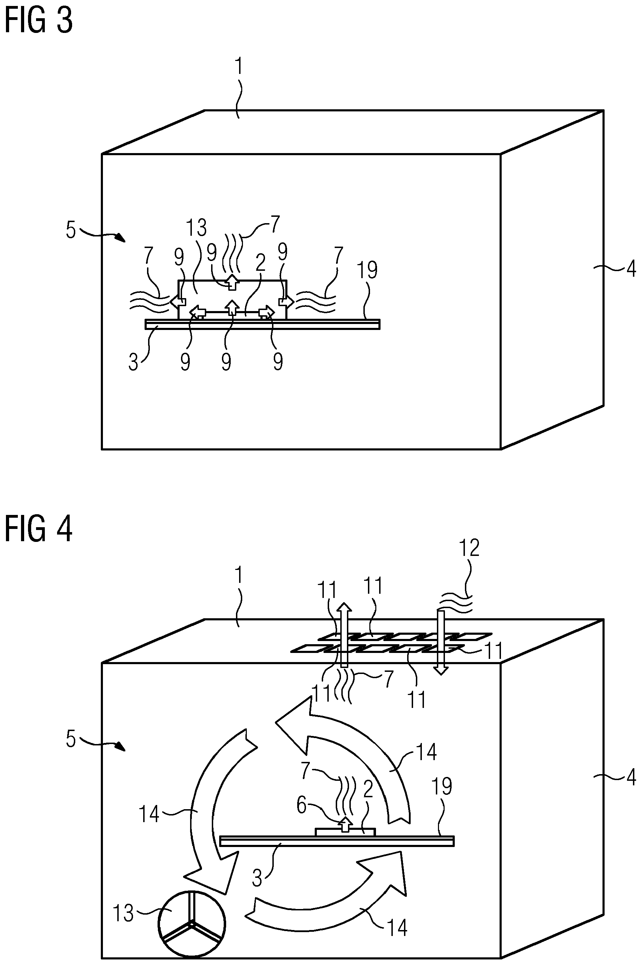

Die FIG 3 zeigt eine dritte schematische Darstellung eines Ausführungsbeispiels des erfindungsgemäßen elektrischen Umrichters 1 nach FIG 1.

Der Leistungshalbleiterschalter 2 ist dabei mechanisch mit dem Trägerelement 3 verbunden und von einem in direktem thermischen Kontakt stehenden und ihn zumindest teilweise umschließenden wärmeleitfähigen, elektrisch nichtleitenden Material 10, insbesondere einem Vergussmaterial, umgeben. Das Trägerelement 3 weist die elektrische Leiterbahn 19 auf, welche mit dem Leistungshalbleiterschalter 2 elektrisch verbunden sein kann.

Im Betrieb des elektrischen Umrichters 1 erzeugt der Leistungshalbleiterschalter 2 eine Verlustwärme, welche mindestens zu 60% bis zu 95% (in FIG 3 nicht im Detail gezeigt) als dritte Verlustwärme 9 unmittelbar an das den Leistungshalbleiterschalter 2 zumindest teilweise umschließende wärmeleitfähige, elektrisch nichtleitende Material 10 abgegeben wird.

Von dem den Leistungshalbleiterschalter 2 zumindest teilweise umschließenden wärmeleitfähigen, elektrisch nichtleitenden Material 10 wird die dritte Verlustwärme 9 mindestens zu 85% bis zu 95% (in FIG 3 nicht im Detail gezeigt) an das gasförmige Umgebungsmedium 7 in den Gehäuseinnenraum 5 des Gehäuses 4 des elektrischen Umrichters 1 abgeführt.

Zwischen 5% und 15% der dritten Verlustwärme 9 kann dabei vom Trägerelement 3 mit seiner elektrischen Leiterbahn 19 aufgenommen und zumindest teilweise an das gasförmige Umgebungsmedium 7 in den Gehäuseinnenraum 5 des Gehäuses 4 des elektrischen Umrichters 1 abgeführt werden.

Eine vierte schematische Darstellung eines weiteren Ausführungsbeispiels des erfindungsgemäßen elektrischen Umrichters 1 nach FIG 1 offenbart FIG 4.

Der Leistungshalbleiterschalter 2 ist dabei mechanisch mit dem Trägerelement 3 verbunden. Das Trägerelement 3 weist die elektrische Leiterbahn 19 auf, welche mit dem Leistungshalbleiterschalter 2 elektrisch verbunden sein kann.

Im Betrieb des elektrischen Umrichters 1 erzeugt der Leistungshalbleiterschalter 2 eine Verlustwärme, welche mindestens zu 60% bis zu 90% (in FIG 4 nicht im Detail gezeigt) als erste Verlustwärme 6 unmittelbar an das gasförmige Umgebungsmedium 7 in den Gehäuseinnenraum 5 des Gehäuses 4 des elektrischen Umrichters 1 abgegeben wird.

Der Gehäuseinnenraum 5 weist ein Mittel 13 zur Erzeugung einer erzwungenen Konvektion 14 auf, welches nach der Darstellung in FIG 4 einem Lüfter - meist elektrisch betreibbar - entspricht.

Darüber hinaus umfasst das Gehäuse 4 des elektrischen Umrichters 1 mehrere Gehäuseöffnungen 11.

Sowohl durch eine natürliche Konvektion wie auch durch die erzwungene Konvektion 14 ist mittels der Gehäuseöffnungen 11 ein Austausch des erwärmten gasförmige Umgebungsmedium 7 aus dem Gehäuseinnenraum 5 des Gehäuses 4 mit einem weiteren gasförmigen Umgebungsmedium 12, insbesondere Umgebungsluft, von außerhalb des Gehäuses 4 des elektrischen Umrichters 1 möglich.

## Patentansprüche

1. Elektrischer Umrichter (1), aufweisend
- einen Leistungshalbleiterschalter (2) mit breitem Bandabstand aus GaN oder aus InGaN,
- ein Trägerelement (3) zur mechanischen Aufnahme des Leistungshalbleiterschalters (2) und
- ein Gehäuse (4), in dessen Gehäuseinnenraum (5) das Trägerelement (3) mit dem Leistungshalbleiterschalter (2) angeordnet ist, wobei
- der Leistungshalbleiterschalter (2) im Betrieb des elektrischen Umrichters (1) mit einer Sperrspannung von mindestens 400V und mit einer Taktfrequenz von mindestens 40kHz betrieben wird und
- mindestens 60% bis zu 90% der durch den Leistungshalbleiterschalter (2) entstehenden Verlustwärme als eine erste Verlustwärme (6) zur Entwärmung an ein gasförmiges Umgebungsmedium (7) innerhalb des Gehäuseinnenraums (5) abgeführt wird.

2. Elektrischer Umrichter (1) nach Anspruch 1, wobei der Leistungshalbleiterschalter (2) im Betrieb des elektrischen Umrichters (1) mindestens 10% bis zu 40% seiner entstehenden Verlustwärme als eine zweite Verlustwärme zur Entwärmung (8) unmittelbar an das Trägerelement (3) abgibt und von dort die zweite Verlustwärme (8) mindestens zu 85% bis zu 95% an das gasförmige Umgebungsmedium (7) innerhalb des Gehäuseinnenraums (5) abgeführt wird.

3. Elektrischer Umrichter (1) nach einem der Ansprüche 1 oder 2, wobei die erste Verlustwärme (6) des Leistungshalbleiterschalters (2) unmittelbar an das gasförmige Umgebungsmedium (7) innerhalb des Gehäuseinnenraums (5) abgeführt wird.

4. Elektrischer Umrichter (1) nach einem der Ansprüche 1 oder 2, wobei der Leistungshalbleiterschalter (2) im Betrieb des elektrischen Umrichters (1) mindestens 60% bis zu 90% seiner entstehenden Verlustwärme als eine dritte Verlustwärme (9) zur Entwärmung unmittelbar an ein in direktem thermischen Kontakt stehendes und ihn zumindest teilweise umschließendes wärmeleitfähiges, elektrisch nichtleitendes Material (10), insbesondere Vergussmaterial, abgibt und von dort die dritte Verlustwärme (9) mindestens zu 85% bis zu 95% an das gasförmige Umgebungsmedium (7) innerhalb des Gehäuseinnenraums (5) abgeführt wird.

5. Elektrischer Umrichter (1) nach einem der vorhergehenden Ansprüche, wobei die Abführung der Verlustwärme des Leistungshalbleiterschalters (2) an das gasförmige Umgebungsmedium (7) im Gehäuseinnenraum (5) ausschließlich durch natürliche Konvektion erfolgt.

6. Elektrischer Umrichter (1) nach einem der Ansprüche 1 bis 4, wobei die Abführung der Verlustwärme des Leistungshalbleiterschalters (2) an das gasförmige Umgebungsmedium (7) im Gehäuseinnenraum (5) zumindest teilweise durch ein Mittel (13) zur Erzeugung einer erzwungenen Konvektion (14) erfolgt.

7. Elektrischer Umrichter (1) nach einem der vorhergehenden Ansprüche, wobei das Gehäuse (4) eine oder mehrere Gehäuseöffnungen (11) aufweist, mittels der im Betrieb des elektrischen Umrichters (1) ein Austausch des erwärmten gasförmigen Umgebungsmediums (7) des Gehäuseinnenraums (5) gegen ein weiteres gasförmiges Umgebungsmedium (12) außerhalb des Gehäuses (4) durchgeführt wird.

8. Elektrischer Umrichter (1) nach einem der vorhergehenden Ansprüche, wobei das Gehäuse (4) mindestens zu 95% ein wärmeleitfähiges, nichtmetallisches Material, insbesondere Kunststoff, aufweist.

9. Elektrischer Umrichter (1) nach einem der vorhergehenden Ansprüche, wobei der Leistungshalbleiterschalter (2) im Betrieb des elektrischen Umrichters (1) mit einem Schaltstrom von mindestens 7A betrieben wird.

10. Elektrischer Umrichter (1) nach einem der vorhergehenden Ansprüche, aufweisend als Leistungshalbleiterschalter (2) mit breitem Bandabstand aus GaN oder aus InGaN einen ersten Leistungshalbleiterschalter (15) und einen oder mehrere weitere Leistungshalbleiterschaltern (16), welche an einem ersten Trägerelement (17) als Trägerelement (3) oder an einem ersten Trägerelement (17) und einem oder mehreren weiteren Trägerelementen (18) als Trägerelement (3) angeordnet sind.
